# EUROPÄISCHE PATENTSCHRIFT

(11) **EP 2 031 754 B1**
(45) Veröffentlichungstag und Bekanntmachung des Hinweises auf die Patenterteilung: **03.08.2011**
(21) Anmeldenummer: 08105099.9
(22) Anmeldetag: 22.08.2008
(51) Int. Cl.: H03D 7/00, H03L 7/06, H04B 1/30, H03D 3/24, H04B 1/00

(54) **Frequenzumsetzer für den Zwischenfrequenzverstärker eines Rundfunkgerätes**
Frequency converter for the intermediate frequency amplifier of a radio device
Convertisseur de fréquence pour le renforcement de fréquence intermédiaire d'un appareil radio

(30) Priorität: 31.08.2007 DE 102007041283
(43) Veröffentlichungstag der Anmeldung: 04.03.2009
(73) Patentinhaber: Loewe Opta GmbH, 96317 Kronach (DE)
(72) Erfinder: Baier, Oliver, 96224, Burgkunstadt (DE)
(74) Vertreter: Eichstädt, Alfred

(56) Entgegenhaltungen:
- EP-B1- 0 654 914
- WO-A1-2007/080918
- DE-B- 1 105 921

## Beschreibung

Die Erfindung betrifft einen Frequenzumsetzer für den Zwischenfrequenzverstärker eines Rundfunkgerätes.

Heutige Zwischenfrequenzverstärker von Rundfunkgeräten enthalten Prozessoren mit integrierten Frequenzumsetzern, die der Frequenzumsetzung eines Eingangssignals in ein niederfrequenteres Ausgangssignal dienen. Angewendet werden derartige Zwischenfrequenzverstärker beispielsweise bei der Umsetzung von DVB-Signalen von einer Eingangsfrequenz in eine zu einer Weiterverarbeitung geeignetere Ausgangsfrequenz, beispielsweise von 36 MHz-Signalen in 6 MHz-Signale. Weiterhin können derartige Zwischenfrequenzverstärker auch zu einer Frequenzumsetzung von Ton-Zwischenfrequenzsignalen verwendet werden, beispielsweise von 33,3 MHz-Signalen in 10,7 MHz-Signale.

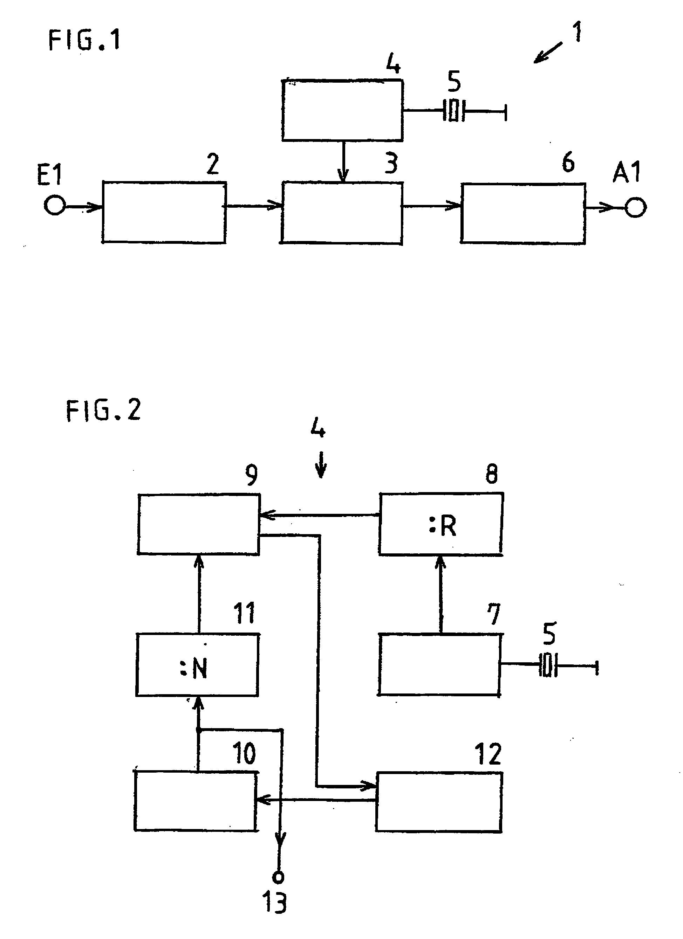

Der grundsätzliche Aufbau eines derartigen Frequenzumsetzers ist in der Figur 1 dargestellt. Dieser Frequenzumsetzer 1 weist einen Eingang E1 auf, an welchem ein erstes Zwischenfrequenzsignal anliegt. Dieses durchläuft einen Vorverstärker 2 und gelangt dann auf einen Mischer 3. Das zur Frequenzumsetzung des Signals benötigte Mischsignal wird von einer PLL 4 bereitgestellt, die mit einem ersten Quarz 5 verbunden ist. Das Ausgangssignal des Mischers 3 wird über ein Filter 6 an einen Ausgang A1 des Frequenzumsetzers weitergegeben.

Das am Ausgang A1 bereitgestellte Signal weist aufgrund des erfolgten Mischvorganges eine qualitative Verschlechterung im Hinblick auf Phasenrauschen und Jitter auf. Diese qualitative Verschlechterung äußert sich in einem vergleichsweise niedrigen C/N- bzw. S/N-Verhältnis, welche in Folgeschaltungen Probleme bereiten kann. Diese qualitative Verschlechterung wird hauptsächlich durch die PLL verursacht, die das Mischsignal zur Verfügung stellt.

Der grundsätzliche Aufbau einer derartigen PLL ist in der Figur 2 gezeigt. Die dargestellte PLL 4 ist an einen ersten Quarz 5 angeschlossen, der mit einem quarzgesteuerten Oszillator 7 der PLL verbunden ist. Das Ausgangssignal des quarzgesteuerten Oszillators 7 wird über einen ersten Frequenzteiler 8 an einen Eingang eines Phasenkomparators 9 weitergeleitet. Dem anderen Eingang des Phasenkomparators 9 wird das über einen zweiten Frequenzteiler 11 geführte Ausgangssignal eines spannungsgesteuerten Oszillators 10 zugeführt. Das Ausgangssignal des Phasenkomparators 9 wird über ein Schleifenfilter 12 dem spannungsgesteuerten Oszillator 10 zugeführt, um diesen nachzuregeln. Das Ausgangssignal des spannungsgesteuerten Oszillators 10 wird des Weiteren an einen Mischsignalausgang 13 der PLL 4 weitergeleitet und von dort aus als Mischsignal an den in der Figur 1 gezeigten Mischer 3 weitergegeben.

Durch die Verwendung der genannten Frequenzteiler, bei denen es sich um programmierbare Frequenzteiler handelt, kann das zur Verfügung gestellte Mischsignal in Schritten, die einem Vielfachen der Referenzfrequenz entsprechen, variiert werden. Die Referenzfrequenz ist dabei der Quotient aus der Quarzfrequenz und dem Teilungsfaktor R des ersten Frequenzteilers 8.

Ziel einer derartigen PLL ist es, dem Anwender eine Vielzahl verschiedener Mischfrequenzen zugänglich zu machen. Während das vom quarzgesteuerten Oszillator 7 bereitgestellte Signal rauscharm und jitterarm ist, wird aufgrund des Aufbaus des spannungsgesteuerten Oszillators und der erfolgenden Regelvorgänge innerhalb der PLL das von der PLL bereitgestellte Mischsignal hinsichtlich dieser Eigenschaften verschlechtert.

Aus der DE 10 2004 020 551 A1 ist eine Vorrichtung für den Empfang von Rundfunksignalen bekannt, die zum Empfang mindestens eines digital übertragenen Rundfunksignals und zum Empfang mindestens eines analog oder analog und digital gemischten übertragenen Rundfunksignals vorgesehen ist. Zur Umsetzung des zumindest einen analog übertragenen Rundfunksignals auf eine Zwischenfrequenz werden Signale verwendet, die von Empfängerkomponenten wie beispielsweise der Signalquelle des Mischoszillatorsignals ausgegeben werden, die zur Frequenzumsetzung des mindestens einen digital übertragenen Rundfunksignals vorgesehen sind. Beim Empfang von Rundfunksignalen im Band III, im L-Band und im FM-Band erfolgt eine Frequenzumsetzung des empfangenen Signals jeweils unter Verwendung des Ausgangssignals eines spannungsgesteuerten Oszillators, der mit einer Phasenregelschleife verbunden ist. Das Ausgangssignal des spannungsgesteuerten Oszillators wird dem jeweiligen Mischer entweder direkt oder über einen Frequenzteiler zugeführt. Beim Empfang von Rundfunksignalen im AM-Band erfolgt eine Frequenzumsetzung unter Verwendung des Ausgangssignals eines Referenzoszillators derart, dass das im AM-Band empfangene Signal in das FM-Band umgesetzt wird.

Aus der DE 11 05 921 A ist ein frequenzstabiler Vielkanal-UKW-Überlagerungsempfänger mit mindestens zwei verschiedenen Zwischenfrequenzen bekannt. Die Überlagerungsfrequenz der ersten Mischstufe wird als Summe oder Differenz zweier Hilfsfrequenzen erzeugt, von denen eine quarzstabilisiert und die andere veränderbar ist. Die mittlere Frequenz und der Frequenzbereich der veränderbaren Hilfsfrequenz des ersten Überlagerungsoszillators stimmen zahlenmäßig etwa mit der mittleren Frequenz und dem Frequenzbereich des zweiten Überlagerungsoszillators überein. Die quarzstabilisierte Hilfsfrequenz, die veränderbare Hilfsfrequenz des ersten Überlagerungsoszillators und die Frequenz des zweiten Überlagerungsoszillators sind derart gewählt, dass sie eine vorgegebene Beziehung erfüllen. An den quarzstabilisierten Hilfsoszillator sind unter Verwendung eines Schalters verschiedene Quarze anschaltbar.

Aus der WO 2007/080918 A1 und der dazu korrespondierenden, jedoch nicht vorveröffentlichten EP 1 978 639 A1 ist eine PLL bekannt, die einen Quarzoszillator und einen spannungsgesteuerten Oszillator aufweist. Die Ausgangssignale des Quarzoszillators und des spannungsgesteuerten Oszillators werden in einem Phasenkomparator miteinander verglichen. Das Ausgangssignal des Phasenkomparators wird über eine Ladungspumpe und ein Tiefpassfilter zur Nachregelung an den spannungsgesteuerten Oszillator zurückgeführt.

Aus der EP 0 654 914 B1 ist eine Spread-Sektrum-Demoduliervorrichtung bekannt. Diese weist einen Mischer auf, der an eine Antenne angeschlossen ist und mit einem von einem Pseudorauschgenerator erzeugten Mischsignal beaufschlagt wird. Des Weiteren enthält die bekannte Vorrichtung eine PLL, die einen spannungsgesteuerten Oszillator, einen Phasenkomparator und ein Schleifenfilter aufweist. Das Ausgangssignal des Schleifenfilters wird über einen Pegeldiskriminator und einen Steuersignalgenerator als Steuersignal für einen Schalter verwendet. In einer ersten Schaltstellung dieses Schalters ist ein Oszillator mit dem Eingang des Pseudorauschgenerators verbunden. In der zweiten Schaltstellung dieses Schalters ist ein an einem Eingang BIn bereitgestelltes Eingangssignal mit dem Eingang des Pseudorauschgenerators verbunden.

Die Aufgabe der Erfindung besteht darin, einen Frequenzumsetzer anzugeben, der die oben beschriebenen Nachteile nicht aufweist.

Diese Aufgabe wird durch einen Frequenzumsetzer mit den im Anspruch 1 angegebenen Merkmalen gelöst. Vorteilhafte Ausgestaltungen und Weiterbildungen der Erfindung ergeben sich aus den abhängigen Patentansprüchen.

Die Vorteile der Erfindung bestehen insbesondere darin, dass der Anwender nach wie vor auf die hohe Frequenzvarianz, die auf der Verwendung einer PLL beruht, zugreifen kann, andererseits aber auch die Möglichkeit hat, bei Anwendungen, die hohe qualitative Anforderungen an das Mischsignal stellen, auf das hochwertige Ausgangssignal des quarzgesteuerten Oszillators zuzugreifen.

Weitere Vorteile der Erfindung bestehen darin, dass sie mit nur geringen Eingriffen in das Schaltungsdesign des Zwischenfrequenzverstärkers bzw. Zwischenfrequenzprozessors realisiert werden kann.

Nachfolgend wird die Erfindung anhand der Figuren beispielhaft erläutert. Es zeigt
- Figur 1: eine Blockdarstellung eines Frequenzumsetzers,
- Figur 2: eine Blockdarstellung einer PLL gemäß dem Stand der Technik,
- Figur 3: eine Blockdarstellung einer PLL gemäß einem ersten Ausführungsbeispiel für die Erfindung und
- Figur 4: eine Blockdarstellung einer PLL gemäß einem zweiten Ausführungsbeispiel für die Erfindung.

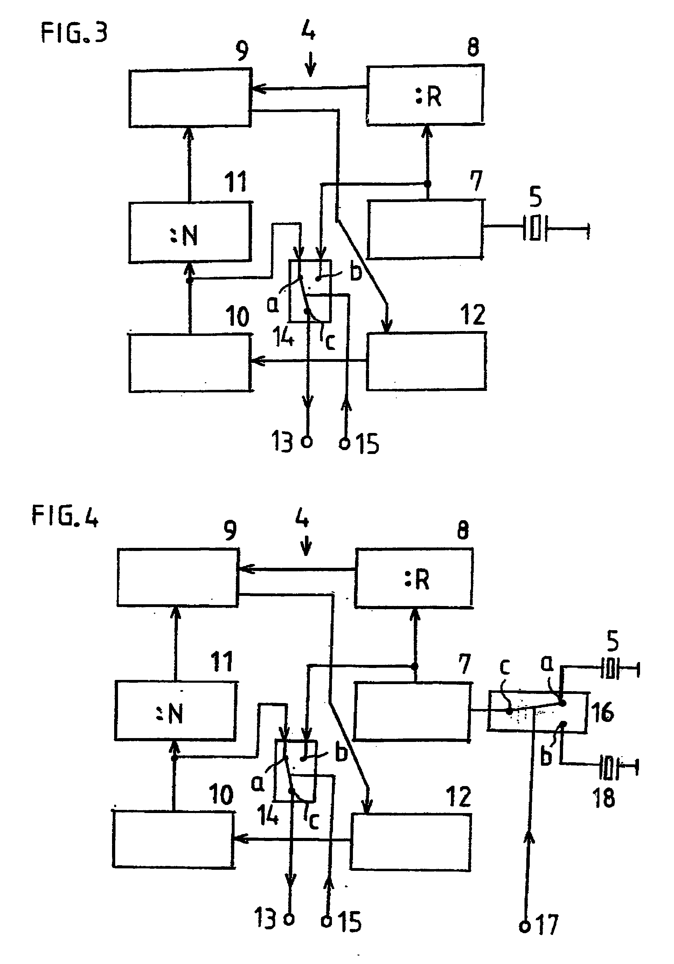

Die Figur 3 zeigt eine Blockdarstellung einer PLL gemäß einem ersten Ausführungsbeispiel für die Erfindung. Die in der Figur 3 gezeigte PLL kann anstelle der in der Figur 2 gezeigten PLL als PLL 4 des in der Figur 1 gezeigten Frequenzumsetzers verwendet werden.

Die in der Figur 3 dargestellte PLL 4 ist ebenso wie die in der Figur 2 gezeigte PLL an einen ersten Quarz 5 angeschlossen, der mit einem quarzgesteuerten Oszillator 7 der PLL verbunden ist. Das Ausgangssignal des quarzgesteuerten Oszillators 7 wird über einen ersten Frequenzteiler 8 an einen Eingang eines Phasenkomparators 9 weitergeleitet. Dem anderen Eingang des Phasenkomparators 9 wird das über einen zweiten Frequenzteiler geführte Ausgangssignal eines spannungsgesteuerten Oszillators 10 zugeführt. Das Ausgangssignal des Phasenkomparators 9 wird über ein Schleifenfilter 12 dem spannungsgesteuerten Oszillator 10 zugeführt, um diesen nachzuregeln.

Das Ausgangssignal des spannungsgesteuerten Oszillators 10 wird vom Ausgang des spannungsgesteuerten Oszillators 10 an einen Kontakt a eines ersten Schalters 14 geleitet. Das Ausgangssignal des quarzgesteuerten Oszillator 7 wird vom Ausgang des quarzgesteuerten Oszillators 7 an einen Kontakt b des ersten Schalters 14 geleitet. Der Kontakt c des ersten Schalters 14 ist mit dem Mischsignalausgang 13 der PLL verbunden.

Befindet sich der erste Schalter 14 in seiner Schalterstellung a, dann wird das Ausgangssignal des spannungsgesteuerten Oszillators 10 am Mischsignalausgang 13 der PLL 4 bereitgestellt. Befindet sich der Schalter 14 hingegen in seiner Schalterstellung b, dann wird das Ausgangssignal des quarzgesteuerten Oszillators 7 am Mischsignalausgang 13 der PLL 4 bereitgestellt.

Die Steuerung des ersten Schalters 14 erfolgt mittels eines ersten Schaltersteuersignals, welches der PLL an einem ersten Steuereingang 15 bereitgestellt wird. Dieses Schaltersteuersignal wird beispielsweise über einen mit dem Zwischenfrequenzverstärker verbundenen Bus übertragen und dann dem ersten Steuereingang 15 zugeführt.

Als erster Quarz 5 wird bei diesem Ausführungsbeispiel ein Quarz verwendet, welcher Signale mit der am Mischsignalausgang 13 benötigten Mischsignalfrequenz liefert. Alternativ dazu kann auch ein Frequenzteiler verwendet werden, mittels dessen die vom Quarz 5 bereitgestellten Frequenzsignale in Signale umgewandelt werden, die die benötigte Mischsignalfrequenz aufweisen. Durch eine geeignete Auslegung der verwendeten Frequenzteiler kann dabei sichergestellt werden, dass die an den Kontakten a und b des ersten Schalters 14 bereitgestellten Mischsignale bezüglich ihres Frequenzbereiches übereinstimmen.

Bei diesem Ausführungsbeispiel besteht nach alledem die Möglichkeit, entweder die vom quarzgesteuerten Oszillator 7 bereitgestellten Signale als Mischsignal am Mischsignalausgang 13 der PLL 4 bereitzustellen oder die vom Ausgang des spannungsgesteuerten Oszillators 10 abgeleiteten Signale als Mischsignal am Mischsignalausgang 13 der PLL 4 bereitzustellen.

Der Anwender hat folglich die Möglichkeit, entweder auf die hohe Frequenzvarianz der PLL zuzugreifen oder beim Vorliegen von Anwendungen, die hohe qualitative Anforderungen an das Mischsignal stellen, auf das hochwertige Signal des quarzgesteuerten Oszillators 7 zuzugreifen.

Eine vorteilhafte Weiterbildung besteht darin, dann, wenn sich der erste Schalter 14 in seiner Schalterstellung b befindet, den spannungsgesteuerten Oszillator 10 zu deaktivieren, so dass Energie eingespart wird.

Die Figur 4 zeigt eine Blockdarstellung einer PLL gemäß einem zweiten Ausführungsbeispiel für die Erfindung. Die in der Figur 4 gezeigte PLL kann anstelle der in der Figur 2 gezeigten PLL als PLL 4 des in der Figur 1 gezeigten Frequenzumsetzers verwendet werden.

Die in der Figur 4 gezeigte Anordnung unterscheidet sich von der in der Figur 3 gezeigten Anordnung dadurch, dass der erste Quarz 5 über einen zweiten Schalter 16 mit dem quarzgesteuerten Oszillator 7 verbunden ist. Befindet sich dieser zweite Schalter 16 in seiner Schalterstellung a, dann ist der erste Quarz 5 mit dem quarzgesteuerten Oszillator 7 verbunden. Befindet sich der zweite Schalter 16 hingegen in seiner Schalterstellung b, dann ist der quarzgesteuerte Oszillator 7 mit einem zweiten Quarz 18 verbunden.

Die Steuerung des zweiten Schalters 16 erfolgt mittels eines zweiten Schaltersteuersignals, welches der PLL über einen zweiten Steuereingang 17 bereitgestellt wird. Dieses zweite Schaltersteuersignal wird beispielsweise über einen mit dem Zwischenfrequenzverstärker verbundenen Bus übertragen und dann dem zweiten Steuereingang 17 zugeführt.

Durch diese zusätzliche Auswahlmöglichkeit von zwei oder auch noch mehr Quarzen wird es möglich, den Zwischenfrequenzverstärker nicht nur im Hinblick auf analoge Rundfunksignale oder digitale Rundfunksignale zu optimieren, sondern nach Bedarf einzustellen. Beispielsweise kann beim Empfang von FM-Radiosignalen, wobei eine Frequenzumsetzung vom 33,3 MHz-Bereich in den 10,7 MHz-Bereich erfolgt, und beim Empfang von terrestrischen digitalen Fernsehsignalen, wobei eine Frequenzumsetzung vom 36 MHz-Bereich in den 6 MHz-Bereich erfolgt, jeweils ein eigener Quarz verwendet werden. Des Weiteren ist ein kontinuierlicher Mischbetrieb zwischen Nutzung der PLL und Nutzung eines rauscharmen quarzgesteuerten Oszillators möglich.

Beispielsweise befindet sich beim Vorliegen von über Kabel empfangenen digitalen Fernsehsignalen der erste Schalter 14 in seiner Schalterstellung a, so dass PLL-Betrieb vorliegt. Beim Vorliegen von terrestrisch empfangenen Fernsehsignalen befindet sich der erste Schalter 14 in seiner Schalterstellung b und der zweite Schalter 16 ebenfalls in seiner Schalterstellung b, so dass auf den zweiten Quarz 18 zugegriffen wird. Beim Vorliegen von FM-Radiosignalen befindet sich der erste Schalter 14 ebenfalls in seiner Schalterstellung b, der zweite Schalter 16 aber in seiner Schalterstellung a, so dass auf den ersten Quarz 5 zugegriffen wird.

Unabhängig davon lassen sich im PLL-Betrieb, in welchem sich der erste Schalter 14 in seiner Schalterstellung a befindet, aufgrund der Möglichkeit, auf zwei verschiedene Quarze zugreifen zu können, Schrittweiten einstellen, die mit einem Quarz alleine nicht verfügbar wären. Dadurch wird die Frequenzvarianz der PLL weiter vergrößert.

Die nachfolgende Tabelle gibt einen Überblick über verschiedene Anwendungen, die aufgrund der in der Figur 4 gezeigten Umschaltmöglichkeiten gegeben sind:

| Stellung des Schalters 14 | Stellung des Schalters 16 | PLL für analog und digital | analog (rauscharm) | digital (rauscharm) |
|---|---|---|---|---|
| a | a | Schrittweite A | - | - |
| a | b | Schrittweite B | - | - |
| b | a | - | 33,3 MHz → 10,7 MHz | - |
| b | b | - | - | 36 MHz → 6 MHz |

### Bezugszeichenliste

- 1: Frequenzumsetzer
- 2: Vorverstärker
- 3: Mischer
- 4: PLL
- 5: erster Quarz
- 6: Filter
- 7: quarzgesteuerter Oszillator
- 8: erster Frequenzteiler
- 9: Phasenkomparator
- 10: spannungsgesteuerter Oszillator
- 11: zweiter Frequenzteiler
- 12: Schleifenfilter
- 13: Mischsignalausgang
- 14: erster Schalter
- 15: erster Steuereingang
- 16: zweiter Schalter
- 17: zweiter Steuereingang
- 18: zweiter Quarz

- E1: Eingang
- A1: Ausgang
- a, b: Schalterstellungen

## Patentansprüche

1. Frequenzumsetzer für den Zwischenfrequenzverstärker eines Rundfunkgerätes, mit
- einem Mischer (3), einer mit dem Mischer verbundenen PLL (4) und einem mit der PLL verbundenen ersten Quarz (5), wobei
- die PLL (4) einen vom ersten Quarz (5) gesteuerten Oszillator (7), einen spannungsgesteuerten Oszillator (10), einen Phasenkomparator (9) und einen mit dem Mischer (3) verbundenen Mischsignalausgang (13) aufweist,
- der Ausgang des vom ersten Quarz (5) gesteuerten Oszillators (7) über einen ersten Frequenzteiler (8) mit einem ersten Eingang des Phasenkomparators (9) verbunden ist,
- der Ausgang des spannungsgesteuerten Oszillators (10) über einen zweiten Frequenzteiler (11) mit einem zweiten Eingang des Phasenkomparators (9) verbunden ist,
- das Ausgangssignal des Phasenkomparators (9) über ein Schleifenfilter (12) dem spannungsgesteuerten Oszillator (10) zugeführt wird, um diesen nachzuregeln, **dadurch gekennzeichnet, dass**
- zwischen dem spannungsgesteuerten Oszillator (10) und dem Mischsignalausgang (13) der PLL ein erster Schalter (14) vorgesehen ist, in dessen erster Schalterstellung (a) der Ausgang des spannungsgesteuerten Oszillators (10) mit dem Mischsignalausgang (13) verbunden ist und in dessen zweiter Schalterstellung (b) der Ausgang des quarzgesteuerten Oszillators (7) mit dem Mischsignalausgang (13) verbunden ist.

2. Frequenzumsetzer nach Anspruch 1, **dadurch gekennzeichnet, dass** er einen ersten Steuereingang (15) aufweist, über welchen dem ersten Schalter (14) ein erstes Schaltersteuersignal zuführbar ist.

3. Frequenzumsetzer nach Anspruch 2, **dadurch gekennzeichnet, dass** er an einen Datenbus angeschlossen ist und das erste Schaltersteuersignal dem ersten Steuereingang (15) über den Datenbus zuführbar ist.

4. Frequenzumsetzer nach einem der vorhergehenden Ansprüche, **dadurch gekennzeichnet, dass** in der zweiten Schalterstellung (b) des ersten Schalters (14) der spannungsgesteuerte Oszillator (10) deaktiviert ist.

5. Frequenzumsetzer nach einem der vorhergehenden Ansprüche, **dadurch gekennzeichnet, dass** der quarzgesteuerte Oszillator (7) mit dem ersten Quarz (5) über einen zweiten Schalter (16) verbunden ist, in einer ersten Schalterstellung (a) des zweiten Schalters der quarzgesteuerte Oszillator (7) mit dem ersten Quarz (5) und in einer zweiten Schalterstellung (b) des zweiten Schalters der quarzgesteuerte Oszillator (7) mit einem zweiten Quarz (18) verbunden ist.

6. Frequenzumsetzer nach Anspruch 5, **dadurch gekennzeichnet, dass** er einen zweiten Steuereingang (17) aufweist, über welchen dem zweiten Schalter (16) ein zweites Schaltersteuersignal zuführbar ist.

7. Frequenzumsetzer nach Anspruch 6, **dadurch gekennzeichnet, dass** das zweite Schaltersteuersignal dem zweiten Steuereingang (17) über den Datenbus zuführbar ist.

8. Frequenzumsetzer nach einem der Ansprüche 5 - 7, **dadurch gekennzeichnet , dass** der erste Schalter (14) sich bei einem Empfang von digitalen Fernsehsignalen über Kabel in seiner ersten Schalterstellung (a) befindet und bei einem Empfang von terrestrisch ausgestrahlten digitalen Fernsehsignalen in seiner zweiten Schalterstellung (b) befindet.

9. Frequenzumsetzer nach Anspruch 8, **dadurch gekennzeichnet, dass** der zweite Schalter (16) sich beim Empfang von terrestrisch ausgestrahlten digitalen Fernsehsignalen in seiner zweiten Schalterstellung (b) befindet.

10. Frequenzumsetzer nach einem der Ansprüche 5 - 9, **dadurch gekennzeichnet, dass** bei einem Empfang von FM-Hörrundfunksignalen der erste Schalter (14) sich in seiner zweiten Schalterstellung (b) und der zweite Schalter (16) sich in seiner ersten Schalterstellung (a) befindet.

11. Frequenzumsetzer nach einem der Ansprüche 5 - 7, **dadurch gekennzeichnet, dass** in der ersten Schalterstellung (a) des ersten Schalters (14) bei aktiviertem spannungsgesteuerten Oszillator (10) der zweite Schalter (16) zwischen den beiden Schalterstellungen (a und b) hin und her geschaltet wird.

## Claims

1. Frequency converter for the intermediate frequency amplifier of broadcasting apparatus, comprising
- a mixer (3), a phase-locked loop (4) connected with the mixer and a first quartz (5) connected with the phase-locked loop, wherein
- the phase-locked loop (4) comprises an oscillator (7) controlled by the first quartz (5), a voltage-controlled oscillator (10), a phase comparator (9) and a mixed signal output (13) connected with the mixer (3),
- the output of the oscillator (7) controlled by the first quartz (5) is connected with a first input of the phase comparator (9) by way of a first frequency divider (8),
- the output of the voltage-controlled oscillator (10) is connected with a second input of the phase comparator (9) by way of a second frequency divider (11),
- the output signal of the phase comparator (9) is fed by way of a loop filter (12) to the voltage-controlled oscillator (10),
**characterised in that**
- provided between the voltage-controlled oscillator (10) and the mixed signal output (13) of the phase-locked loop is a first switch (14), in the first switch setting (a) of which the output of the voltage-controlled oscillator (10) is connected with the mixed signal output (13) and in the second switch setting (b) of which the output of the quartz-controlled oscillator (7) is connected with the mixed signal output (13).

2. Frequency converter according to claim 1, **characterised in that** it comprises a first control input (15) by way of which a first switch control signal can be fed to the first switch (14).

3. Frequency converter according to claim 2, **characterised in that** it is connected with a data bus and that the first switch control signal can be fed to the first control input (15) by way of the data bus.

4. Frequency converter according to any one of the preceding claims, **characterised in that** in the second switch setting (b) of the first switch (14) the voltage-controlled oscillator (10) is deactivated.

5. Frequency converter according to any one of the preceding claims, **characterised in that** the quartz-controlled oscillator (7) is connected with the first quartz (5) by way of a second switch (16), in a first switch setting (a) of the second switch the quartz-controlled oscillator (7) is connected with the first quartz (5) and in a second switch setting (b) of the second switch the quartz-controlled oscillator (7) is connected with a second quartz (18).

6. Frequency converter according to claim 5, **characterised in that** it comprises a second control input (17) by way of which a second switch control signal can be fed to the second switch (16).

7. Frequency converter according to claim 6, **characterised in that** the second switch control signal can be fed to the second control input (17) by way of the data bus.

8. Frequency converter according to any one of claims 5 to 7, **characterised in that** the first switch (14) is disposed in a first switch setting (a) in the case of reception of digital television signals by way of cable and in a second switch setting (b) in the case of reception of terrestrially transmitted digital television signals.

9. Frequency converter according to claim 8, **characterised in that** the second switch (16) is disposed in its second switch setting (b) in the case of reception of terrestrially transmitted digital television signals.

10. Frequency converter according to any one of claims 5 to 9, **characterised in that** the first switch (14) is disposed in its second switch setting (b) and the second switch (16) in its first switch setting (a) in the case of reception of frequency-modulated audio broadcasting signals.

11. Frequency converter according to any one of claims 5 to 7, **characterised in that** in the first switch setting (a) of the first switch (14) the second switch (16) is switched back and forth between the two switch settings (a and b) when the voltage-controlled oscillator (10) is activated.

## Revendications

1. Convertisseur de fréquence pour l'amplificateur de fréquence intermédiaire d'un récepteur radio avec
- un mélangeur (3), une PLL (4) branchée au mélangeur et un premier quartz (5) branché à la PLL,
pour lesquels
- la PLL (4) possède un oscillateur (7) commandé par le premier quartz (5), un oscillateur commandé en tension (10), un comparateur de phase (9) et une sortie de signal mixte (13) reliée au mélangeur (3),
- la sortie de l'oscillateur (7) commandé par le premier quartz (5) est branchée à une première entrée du comparateur de phase (9) par un premier diviseur de fréquence (8),
- la sortie de l'oscillateur commandé en tension (10) est branchée à une seconde entrée du comparateur de phase (9) par un deuxième diviseur de fréquence (11),
- le signal de sortie du comparateur de phase (9) est conduit à l'oscillateur commandé en tension (10) par un filtre de boucle (12) afin de réguler l'oscillateur, **caractérisé en ce que**
- entre l'oscillateur commandé en tension (10) et la sortie du signal mixte (13) de la PLL, un premier interrupteur (14) est prévu. Sur sa première position de commutation (a), la sortie de l'oscillateur commandé en tension (10) est connectée avec la sortie du signal mixte (13) et sur sa seconde position de commutation (b), la sortie de l'oscillateur commandé par le quartz (7) est connectée avec la sortie de signal mixte (13).

2. Convertisseur de fréquence selon la revendication 1 **caractérisé en ce qu'**il possède une première entrée de commande (15) grâce auquel un premier signal de commande de l'interrupteur est conduit au premier interrupteur (14).

3. Convertisseur de fréquence selon la revendication 2 **caractérisé en ce qu'**il est branché à un bus de données et que le premier signal de commande de l'interrupteur est conduit à la première entrée de commande (15) par le bus de données.

4. Convertisseur de fréquence selon l'une des revendications précédentes, **caractérisé en ce que** dans la seconde position de commutation (b) du premier interrupteur (14), l'oscillateur commandé en tension (10) est désactivé.

5. Convertisseur de fréquence selon l'une des revendications précédentes **caractérisé en ce que** l'oscillateur commandé par quartz (7) est branché au premier quartz (5) par un second interrupteur (16) et relié dans une première position de commutation (a) du second interrupteur de l'oscillateur commandé par quartz (7) avec le premier quartz (5) et dans une seconde position de commutation (b) du second interrupteur de l'oscillateur commandé par quartz (7) avec un second quartz (18).

6. Convertisseur de fréquence selon la revendication 5 **caractérisé en ce qu'**il possède une deuxième entrée de commande (17) par laquelle un second signal de commande de l'interrupteur est conduit au second interrupteur (16).

7. Convertisseur de fréquence selon la revendication 6 **caractérisé en ce que** le second signal de commande de l'interrupteur est conduit à la seconde entrée de commande (17) par le bus de données.

8. Convertisseur de fréquence selon l'une des revendications 5-7 **caractérisé en ce que** le premier interrupteur (14) se trouve lors de la réception de signaux TV numériques par câble dans sa première position de commutation (a) et lors de la réception de signaux TV numériques transmis par voie terrestre dans sa seconde position de commutation (b).

9. Convertisseur de fréquence selon la revendication 8 **caractérisé en ce que** le second interrupteur (16) se trouve lors de la réception de signaux TV numériques transmis par voie terrestre dans sa seconde position de commutation (b).

10. Convertisseur de fréquence selon l'une des revendications 5-9 **caractérisé en ce que** lors de la réception de signaux radio audio FM le premier interrupteur (14) se trouve dans sa seconde position de commutation (b) et le second interrupteur (16) se trouve dans sa première position de commutation (a).

11. Convertisseur de fréquence selon l'une des revendications 5-7 **caractérisé en ce que** dans la première position de commutation (a) du premier interrupteur (14), lorsque l'oscillateur commandé en tension (10) est activé, le second interrupteur (16) est commuté entre les deux positions de commutation (a et b) sans arrêt.
